# EUROPÄISCHE PATENTSCHRIFT

(11) **EP 1 085 605 B1**
(45) Veröffentlichungstag und Bekanntmachung des Hinweises auf die Patenterteilung: **19.10.2005**
(21) Anmeldenummer: 00115540.7
(22) Anmeldetag: 19.07.2000
(51) Int. Cl.: H01R 12/18, H01R 9/26

(54) **Busleiterabschnitt für ein elektrisches Gerät**
Bus section for an electrical apparatus
Tronçon de bus pour appareil électrique

(30) Priorität: 16.09.1999 DE 29916302 U
(43) Veröffentlichungstag der Anmeldung: 21.03.2001
(73) Patentinhaber: Weidmüller Interface GmbH & Co., 32760 Detmold (DE)
(72) Erfinder: Hanning, Walter, 32758 Detmold (DE); Steinmeier, Rudolf, 32760 Detmold (DE); Zebermann, Christoph, Dr., 37688 Beverungen (DE); Wilmes, Manfred, 32760 Detmold (DE); Richts, Jörg, 33189 Schlangen (DE); Beins, Eckard, 32758 Detmold (DE); Schnatwinkel, Michael, 32051 Herford (DE); Maschler, Thomas, 32760 Detmold (DE)
(74) Vertreter: Specht, Peter

(56) Entgegenhaltungen:
- EP-A- 0 877 542
- DE-A- 3 436 119
- DE-C- 4 140 611

## Beschreibung

Die Neuerung betrifft einen Busleiterabschnitt für ein elektrisches Gerät mit modularem Aufbau zur Steuerung und/oder Überwachung technischer Prozesse und/oder zur Industrie- und/oder Gebäudeautomatisierung, mit wenigstens einem auf eine Tragschiene aufsetzbaren Anschlußmodul für externe Leiter und mit einer Reihung scheibenförmiger Basis-Klemmenträger, wobei innerhalb jedes Anschlußmodules der interne Busleiterabschnitt im wesentlichen parallel zur Tragschiene verläuft.

Ein gattungsgemäßer Busleiterabschnitt für ein elektrisches Gerät ist aus der G 299 01 194 bekannt. Der in dieser Schrift dargestellte Busleiterabschnitt (siehe hierzu auch Fig. 14 dieser Anmeldung) umfaßt einen in eine Öffnung eines Basis-Klemmenträger einer Modulscheibe eingesetzten, internen Busleiterabschnitt, der jeweils eine Platine aufweist, die von einer Reihe Metallstifte durchsetzt ist, welche auf der einen Seite der Platine im wesentlichen senkrecht und auf der gegenüberliegenden Seite der Platine im wesentlichen parallel zur Platine ausgerichtet sind (hier nicht dargestellt). Dabei ist auf die Stiftreihenenden der einen der beiden parallel zur Platine verlaufenden Reihen von Metallstiften eine alle Stiftreihenenden dieser Reihe übergreifende Steckerbuchsenleiste mit Steckerbuchsen(öffnungen) und auf die entsprechenden Stiftreihenenden der anderen Stiftreihe eine Steckerstift-Gehäuseleiste aufgesetzt. Bei nebeneinanderliegenden bzw. aneinandergereihten Basis-Klemmenträgern greifen die Steckerstift-Reihenenden jedes Busleiterabschnitts jeweils in die Steckerbuchsen des Busleiterabschnitts des jeweils benachbarten Basis-Klemmenträgers ein. Da eine der senkrecht zur Platine stehenden Stiftreihen derart lang ausgebildet ist, daß ihre Stiftreihenenden direkt zum Kontaktieren einer direkt an der Elektronik-Leiterplatte angeformten Buchsenleiste zur Elektronik-Leiterplatte genutzt werden können, entfällt die Notwendigkeit zur Ausbildung eines separaten Steckerelementes für diesen Zweck an der Platine des Busleiterabschnitts. Diese Funktion übernehmen vielmehr die Winkelstifte.

Der vorstehend beschriebene Busleiterabschnitt hat sich zwar an sich bewährt. Dennoch besteht der Bedarf nach einer weiteren Optimierung dieses Busleiterabschnittes hinsichtlich einer vereinfachten und/oder kostengünstigen Fertigung bei zumindest gleichbleibender, vorzugsweise aber ebenfalls verbesserter Funktion und mechanischer Stabilität.

Die Erfindung nimmt sich dieses Problems an und löst es durch den Gegenstand des Anspruches 1.

Weitere vorteilhafte Ausführungsformen der Erfindung sind den übrigen Unteransprüchen zu entnehmen. Nachfolgend wird die Erfindung unter Bezug auf die Zeichnung anhand von Ausführungsbeispielen näher beschrieben. Es zeigt:
- Fig. 1 a-e: perspektivische Ansichten von Elementen eines internen Busleiterabschnitts nach einem ersten Ausführungsbeispiel der Erfindung;
- Fig. 2-8: verschiedene Ansichten eines internen Busleiterabschnitts nach einem zweiten Ausführungsbeispiel der Erfindung;
- Fig. 9-13: verschiedene Ansichten eines internen Busleiterabschnitts nach einem dritten Ausführungsbeispiel der Erfindung; und
- Fig. 14: eine Modulscheibe mit einem internen Busleiterabschnitt nach dem Stand der Technik.

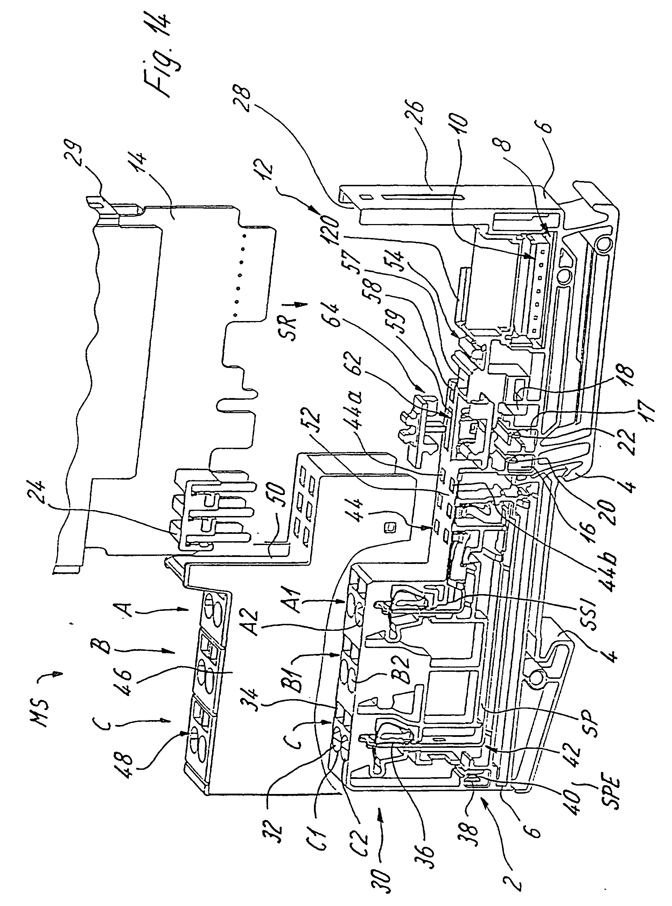

Fig. 14 zeigt eine Modulscheibe MS für ein hier ansonsten nicht dargestelltes Gerät der Automatisierungstechnik. Das Gerät umfaßt ein Gateway (hier nicht dargestellt), an welches u.a. die Modulscheiben MS anreihbar sind. Die Modulscheibe MS ist mit weiteren Modulscheiben MS zu einem Anschlußblock variabler Länge zusammenfügbar.

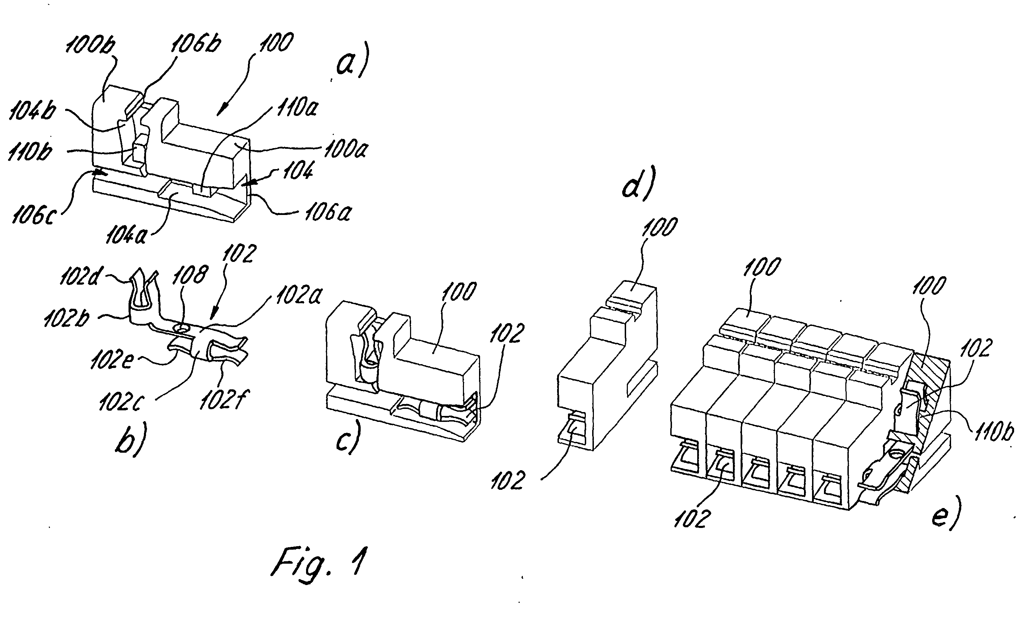

Die Modulscheibe MS weist nach Fig. 1 einen scheibenförmigen Basis-Klemmenträger 2 zur Verriegelung des Einzelmodules auf einer (hier nicht dargestellten) Tragschiene auf. Der Basis-Klemmenträger 2 ist hierzu mit Kunststoff-Rastfüßen 4 versehen, mit denen in an sich bekannter Weise die Rastverbindung zur Tragschiene herstellbar ist. Der Basis-Klemmenträger 2 umfaßt einen unteren Basisabschnitt 6, welcher sich in einen Bereich oberhalb der Tragschienenfüße 4 und neben den Tragschienenfüßen 4 beidseitig über die Tragschiene hinaus erstreckt. In dem Basisabschnitt 6 ist in dem einen von der Tragschiene abgewandt liegenden Außenbereich eine den Basis-Klemmenträger 2 senkrecht zu seiner Haupt-Erstreckungsebene durchdringende Ausnehmung 8 zur Aufnahme des internen Busleiterabschnitts 10 vorgesehen, der eine Weiterleitung der Busleitersignale von Einzelmodul zu Einzelmodul und in die Elektronik-Leiterplatte 14 erlaubt.

Zur Aufnahme der Elektronik-Leiterplatte 14 ist in dem Bereich, welcher sich ungefähr von der Senkrechten zur Mitte der Tragschiene bis zu dem internen Busleiterabschnitt 10 erstreckt, in dem Basis-Klemmenträger 2 eine Umfangs-Ausnehmung 12 ausgebildet. Die Elektronik-Leiterplatte 14 ist mit einer (hier nicht dargestellten) Elektronikschaltung zur Verarbeitung/Weiterleitung der jeweils zur Elektronik-Leiterplatte 14 geführten Signale versehen.

In dem zwischen dem internen Busleiterabschnitt 10 und dem Rastfuß 4 liegenden Bereich ist der Basisabschnitt 6 mit drei weiteren, nebeneinander liegenden Öffnungen 16, 17, 18 versehen, die jeweils senkrecht zur Hauptscheiben- bzw. -modulebene den Basis-Klemmenträger 2 durchdringen, wobei zwei Öffnungen 16, 17 mit als Querbrücken ausgelegten Kontaktelementen 20, 22 versehen sind, welche eine Weitergabe der zugeordneten Potentials von Modul zu Modul ermöglichen. Die weitere Öffnung 18 dient - wie weitere der hier nicht beschriebenen Öffnungen im Basis-Klemmenträger - der Materialersparnis. Von den Querbrückern 20, 22 werden diese Potentiale in die Elektronik-Leiterplatte 14 und/oder über einen geeigneten separaten oder an die Elektronik-Leiterplatte angeformten Stecker 24 zu den Anschlüssen zu den Stromschienen im Basis-Klemmenträger 2 und über diese zu den Anschlußebenen A, B, C der Modulscheibe MS geführt.

Die Ausnehmung 12 wird an dem von der Tragschiene abgewandten Ende des Einzelmodules von einem senkrecht vom Basisabschnitt abstehenden Steg 26 begrenzt, der an seiner zur Tragschiene 4 gewandten Seite mit einer Einschubnut 28 zum Einschieben der Elektronik-Leiterplatte 14 sowie eines Elektronikgehäuses 29 versehen ist.

Ungefähr an dem dem Steg 26 gegenüberliegenden Ende des Basis-Klemmenträgers 2 ist an den Basisabschnitt 6 ein senkrecht nach oben vorstehender Anschlußabschnitt 30 angeformt, der mit den sechs in zwei Reihen zu je drei angeordneten Anschlüssen A1, A2, ... versehen ist. Öffnungen 34 mit quadratischem Querschnitt neben Anschlußöffnungen 32 für die Anschlüsse A1, A2, B1, B2 ... erlauben das Einführen eines Schraubendrehers zum Öffnen der im Anschlußabschnitt 30 angeordneten Feder-Kontaktelemente 36.

Außerhalb der dritten Anschlußebene C ist im Basisabschnitt eine weitere senkrecht zur Modulscheibenebene liegende, den Basis-Klemmenträger 2 durchdringende Öffnung 38 vorgesehen, in welcher ein weiteres Kontaktelement 40 liegt, über das der Schutzleiter PE von Einzelmodul zu Einzelmodul weitergegeben wird.

Die leitende Verbindung zwischen den Kontaktfedern 36 der Anschlüsse A, B, C, ... und der Elektronik-Leiterplatte 14 wird mittels Stromschienen (hier dargestellt: SP für das Pluspotential und SSI für das Signal, nicht zu erkennen: SM für das negative Potential) realisiert. Die Stromschienen SM, SP verlaufen von den Kontaktfedern 36 in seitlichen Nuten/Ausnehmungen 42 des Grundelementes 2 im wesentlichen U-förmig an beiden Hauptaußenflächen des Basis-Klemmenträgers 2. Unterhalb der Aussparung 12 für die Elektronik-Leiterplatte sind die Stromschienen nach oben hin abgewinkelt und verlaufen zur Umfangs-Ausnehmung 12, welche in diesem Bereich mit sechs in zwei Reihen nebeneinander liegenden Anschlußöffnungen 44 zum Aufsetzen des Gerätesteckers 24 an der Elektronik-Leiterplatte und/oder des Leiterplattenrandes versehen ist.

Über den Anschlußabschnitt 30 ist ein Abdeckgehäuse 46 aus Kunststoff aufsetzbar, welches Öffnungen 48 aufweist, die mit den Anschlußöffnungen 32 und den Öffnungen 34 korrespondieren. Zum Bereich der Aussparung 12 des Basis-Klemmenträgers 2 hin ist die Abdeckung ferner mit einer seitlichen Nut 50 versehen, welche im Zusammenwirken mit der Nut 28 die Elektronik-Leiterplatte 14 und das die Elektronik-Leiterplatte 14 schützende Gehäuse 29 aufnimmt, welches in Steckrichtung SR auf den Basis-Klemmenträger 2 aufsetzbar ist.

Der Basis-Klemmenträger 2 bzw. die Modulscheibe MS umfaßt im Bereich der Aussparung 12 an/unterhalb der Grundwandung 52 der Aussparung 12 (von dem Steg 26 aus gesehen nach innen zur Tragschiene hin) folgende Funktionsbereiche: Modulbus(öffnung) BUS / 8, Kennzeichnungskanal (für ein oder zwei Schilder) 54, seitlicher Rasthaken als Verbindung zur Nachbarklemme mit Öffnung 57 zur Betätigung des Rasthakens von oben 57, FE-Kontakt (Funktionserde) 58, Potentialführungs-Kontaktierungsöffnung 59 und Steckerbuchsen/Anschlußöffnungen 44. Neben dem FE-Kontakt 58 und den Öffnungen 44 zu den Potentialführungen PE+, PE- ist eine Ausnehmung 62 für ein Kodierelement 64 vorgesehen.

Fig. 1 zeigt einen internen Busleiterabschnitt 10, der aus einer Aneinanderreihung von Einzelgehäusen 100 besteht, in die jeweils ein Kontaktelement 102 eingesteckt ist. Das Gehäuse 100 und das Kontaktelement 102 weisen in ihrer Seitenansicht eine Art L-Form auf (Fig. 1a und 1b). Das Gehäuse 100 ist an einer seiner L-förmigen Außenseiten mit einer seitlichen Ausnehmung 104 versehen, die nutenartig vollständig sowohl den längeren Schenkel 100a des L (Ausnehmungsbereich 104a) als auch den kürzeren Schenkel 100b von dessen Ende bis zum Ausnehmungsbereich 104a durchzieht (Ausnehmungsbereich 104a). In seinem dem kürzeren Schenkel 100a gegenüberliegenden Endbereich verbreitert sich die Ausnehmung 104, so daß ein Leiter oder ein Leiterplattenrand (nicht dargestellt) von außen in das Gehäuse 100 (bzw. den darin liegenden Kontakt 102) einführbar ist. Auch im kürzeren Schenkel 100a ist eine derartige Verbreiterung vorgesehen, die sich aber am Ende des kurzen Schenkels 100a wieder verjüngt, so daß ein in den kürzeren Schenkel 100b eingesetzter Leiterplattenrand der Leiterplatte 14 an der Gehäuseöffnung des kürzeren Schenkels 100b sicher geführt und gehalten wird und den im kürzeren Schenkel 100b liegenden Kontakt 102 (siehe Fig. 1c) gut kontaktiert. Vorzugsweise werden die Einzelgehäuse 100 mit zusammenwirkenden ersten und zweiten Rastmitteln wie Schwalbenschwanzvorsprüngen und -nuten versehen, welche das Zusammenrasten der Einzelgehäuse ermöglichen (hier nicht dargestellt).

Das Kontaktelement 102 ist als einstückiges Stanz-/Biegeteil ausgebildet, und weist einen Grundsteg 102a, zwei senkrecht zum Grundsteg stehende Querstege 102b, c sowie einen vom Ende des Quersteges 102b und zwei vom Ende des Quersteges 102c senkrecht abstehende kürzere Längsstege 102d,e,f auf. Zwischen den beiden Querstegen 102b,c - bzw. hier im Anschluß an den ersten Quersteg 102b - weist der Längssteg 102a einen Knick um 90° auf. Die Endbereiche der Längsstege 102d,e,f sind jeweils leicht aufgebogen ausgebildet. Auf diese Weise wird ein im wesentlichen L-förmiger Kontakt geformt, der in dem Endbereichen der Schenkel des L zwei tulpenartige Steckkontaktöffnungen 106a, b aufweist. Eine dritte Steckkontaktöffnung 106c wird durch den Längssteg 102e und eine Vertiefung/Auswölbung 108 im Längssteg 102 a ausgebildet. Sie liegt der Steckkontaktöffnung 106a um 180° verdreht gegenüber.

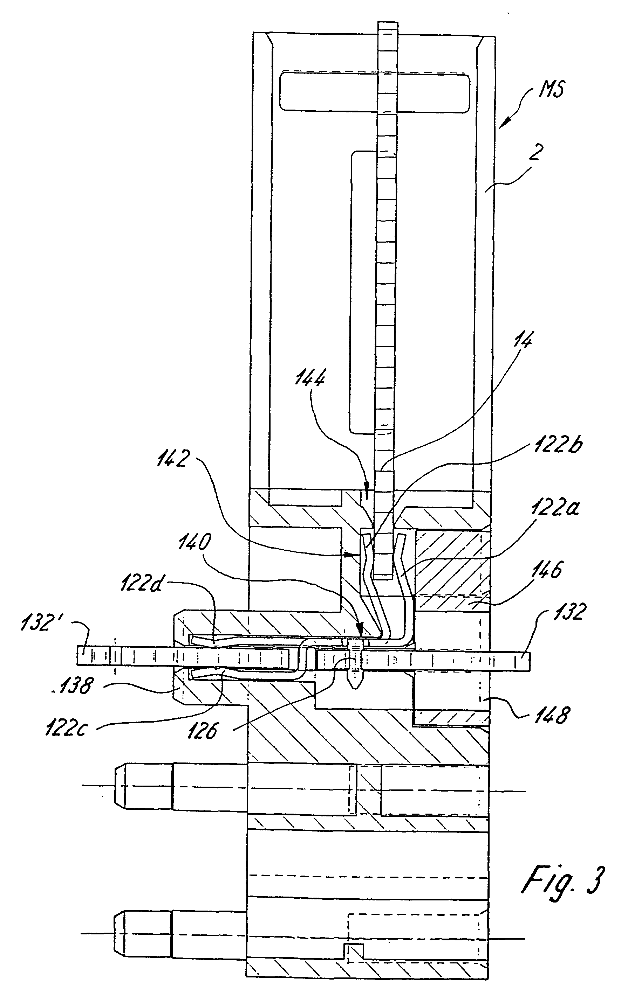

Der in vorstehend beschriebener Weise aufgebaute Steckkontakt 102 ist als einstückiges Stanz-/Biegeteil naturgemäß außerordentlich preiswert. Optional kann er vergoldet - insbesondere auch einseitig selektiv vergoldet - ausgebildet sein. Der Kontakt 102 wird seitlich in die Ausnehmung 104 des Gehäuses 102 eingesetzt. Die Querstege 102b, 102c umgreifen dabei jeweils einen Vorsprung 110 in der Grundwandung der Ausnehmung 104, was den Steckkontakt 102 auf einfache Weise in der Ausnehmung 104 fixiert. Der einstückige Kontakt 102 weist somit drei Steckkontaktöffnungen 106a-c auf (aus drei jeweils um 90° bzw. 180° versetzten Richtungen). In die Steckkontaktöffnung 106b am Ende des kürzeren Schenkels 100b des L-förmigen Gehäuses 100 kann ein Leiterplattenrand eingesetzt werden (siehe hierzu auch Fig. 3). Die beiden Steckkontaktöffnungen 106a und 106c in dem längeren Schenkel 100a des L-förmigen Gehäuses können ebenfalls Leiterplattenränder aufnehmen (hier nicht dargestellt), z.B. die Ränder einer (hier nicht dargestellten) Busleiterplatte zur Weiterleitung des Busses zwischen den Kontakten 102 benachbarter Modulscheiben nach Art der Busleiterplatte 132 in Fig. 3. Zur Bildung des übergreifenden internen Busleiters werden einfach die Gehäuse 100 in oder außerhalb der Busleiteröffnung 8 zusammengesetzt (z.B. mittels Verbindungselementen wie Schwalbenschwanzverbindungen (hier nicht dargestellt)), dann wird jeweils eine Leiterplatte 132 eingesteckt - deren Rand über den Modulscheibenrand vorsteht (wiederum nach Art der Fig. 3) - und die Modulscheiben werden aneinandergereiht, wobei jeweils die über den Rand vorstehenden Leiterplattenränder in den internen Busleiterabschnitt 10 der benachbarten Modulscheibe MS bzw. in die Kontaktelemente 102 der benachbarten Modulscheibe MS eingreifen.

Der interne Busleiter 10 nach Fig. 1 zeichnet sich somit insbesondere dadurch aus, daß zu seiner Herstellung keinerlei Lötschritt sondern lediglich eine unkomplizierte Montage erforderlich ist. Bei genügend hoher Stückzahl ist auch eine Automatenmontage denkbar. Vorteilhaft ist auch, daß die Leiterplatte beidseitig kontaktiert wird. Zudem sind relativ geringe bzw. "weiche" Kontaktkräfte realisierbar. Ein zusätzlicher Vorteil besteht darin, daß die Herstellung des internen Busleiters 10 ohne ein zusätzliches Kontaktelement auf der Leiterplatte 14 oder 132 möglich ist, da zur Kontaktierung der Leiterplattenrand genutzt wird. Schließlich ist noch hervorzuheben, daß der interne Busleiterabschnitt der Fig. 1 eine fest definierte Winkligkeit von 90° aufweist, da keinerlei "biegsame" Teile wie Metallstifte aus ihrer vorgegebenen Position im Gehäuse 100 abweichen können.

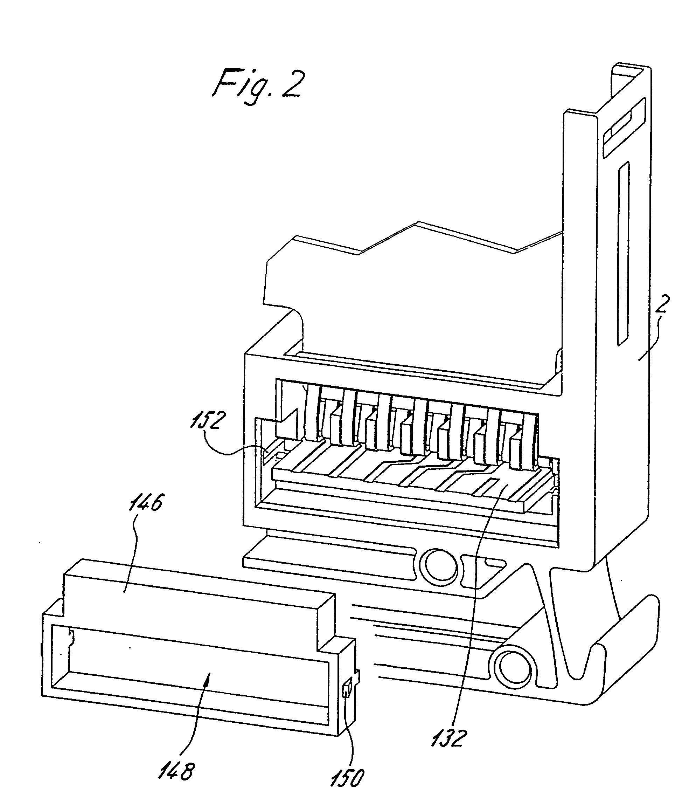

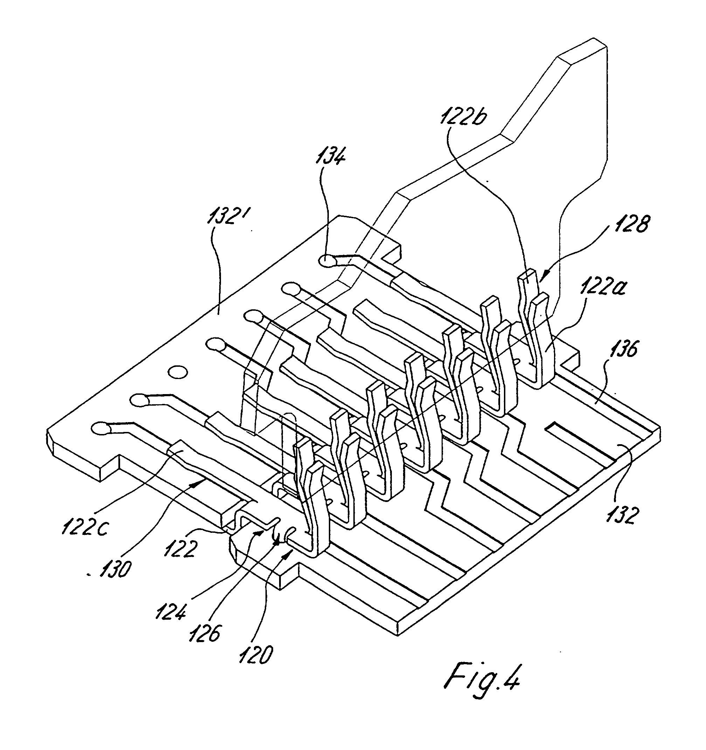

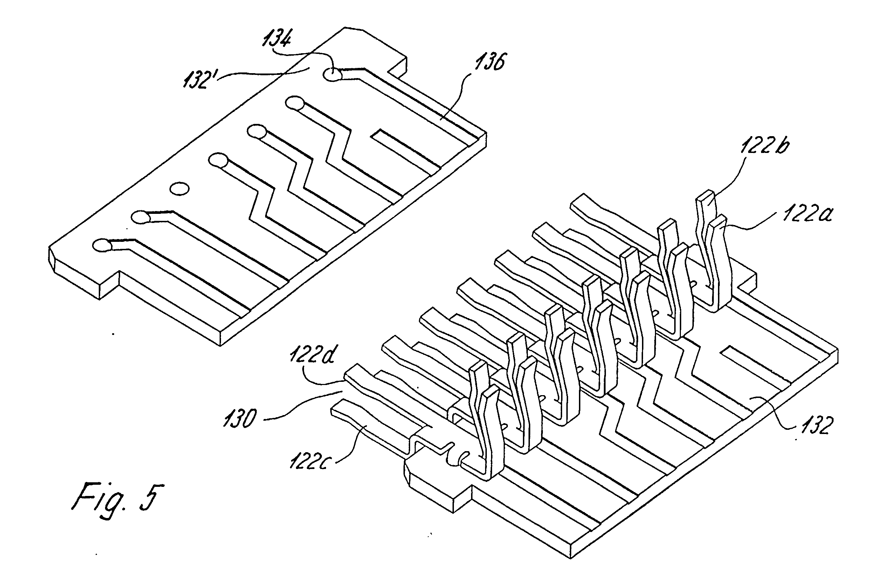

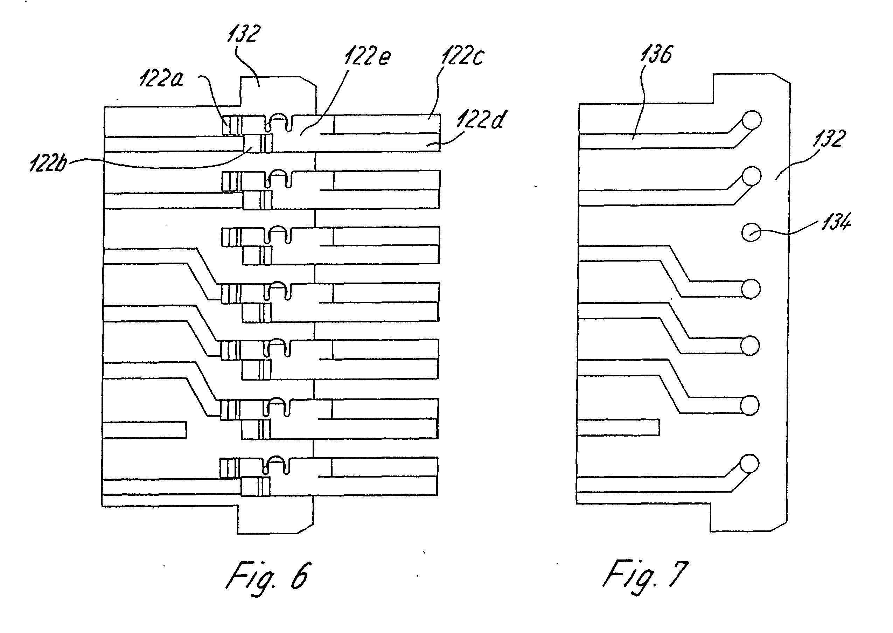

Die Fig. 2 bis 8 zeigen ein weiteres Ausführungsbeispiel eines erfindungsgemäßen internen Busleiters 10. Dieser interne Busleiter 10 besteht aus einer Mehrzahl von Kontaktelementen 120, die wiederum einstückig als Stanz-/Biegeteile ausgebildet sind, gefertigt aus (hier nicht dargestellten) Blechstreifenstücken.

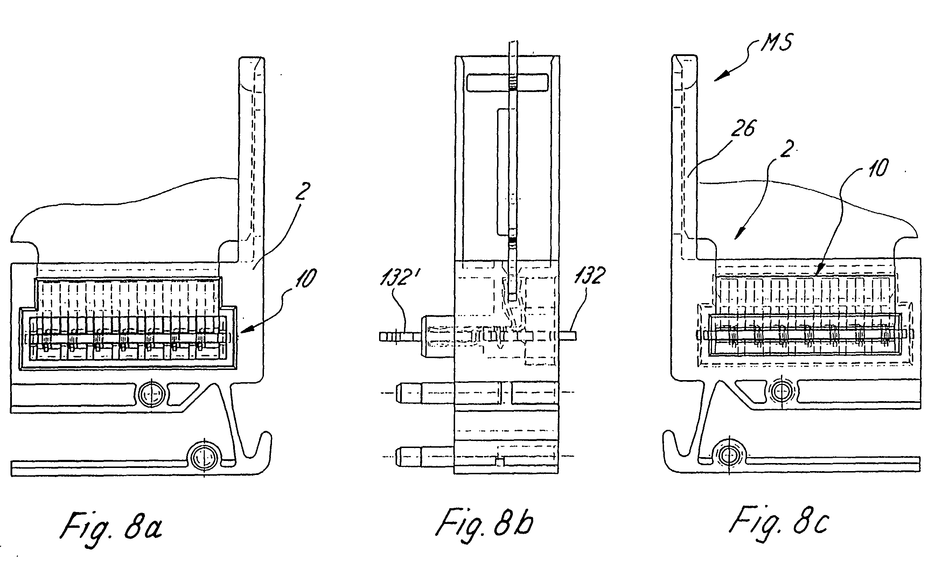

Die ausgestanzten Blechstreifen zum Biegen der Kontaktelemente 120 weisen im wesentlichen eine langgezogene, rechteckige Form auf, wobei die gegenüberliegenden schmaleren Seiten des Rechteckes jeweils geschlitzt ausgebildet sind. Im Bereich dieser Schlitze bilden sich vier Kontaktfahnen 122 aus, welche jeweils entsprechend zu ihren Kontaktierungsaufgaben umgebogen werden. Im mittleren Bereich des Kontaktelementes 120 ist die eine der Längsseiten mit zwei senkrechten Einschnitten 124 versehen, die parallel zueinander ausgerichtet sind und derart eng zueinander liegen, daß zwischen ihnen ein Blechstreifenabschnitt ausgebildet wird, der gegenüber dem Blechstreifen um 90° nach unten umgebogen werden kann und ebenfalls als Kontaktfahne bzw. als Löt- und/oder Einpreßstift 126 dient. Alternativ ist hier eine SMD-Fläche (bzw./oder SMT-Fläche) ausbildbar. Zwei der Kontaktfahnen 122 a,b sind im wesentlichen um 180° zum Lötstift 180° verdreht nach oben vom Blechstreifen 120 abgebogen und zwar derart leicht versetzt zueinander, daß zwischen den beiden Kontaktfahnen 122a,b ein in der Seitenansicht tulpenartiger Aufnahmebereich 128 zur Aufnahme eines Leiterplattenrandes einer Leiterplatte 14 entsteht (siehe auch Fig. 8b). Die den Kontaktfahnen 122a,b am anderen axialen Ende des Blechstreifens gegenüberliegenden Kontaktfahnen 122c,d bilden ebenfalls eine Art tulpenförmige Aufnahme 130 für den Rand einer Leiterplatte 132 aus, diese liegt jedoch um ca. 90° zur Leiterplatte 14 gedreht. Hierzu ist die Kontaktfahne 122c zunächst um 90° nach unten gebogen und dann nach einer Strecke, die der Dicke der Leiterplatte 132 entspricht, nochmals um 90° in Richtung der Leiterplatte 132 abgebogen. Die Kontaktfahne 122d erstreckt sich dagegen im wesentlichen in der Hauptebene des Kontaktelementes 120 parallel zur Leiterplatte 132. Alle Kontaktfahnen 122a-d sind zudem in ihrem Endbereich derart zunächst nach innen und dann nach außen aufgebogen, daß sich die Enden der Aufnahmen 128, 130 tulpenartig aufweiten und den Leiterplattenrand leicht federnd vorgespannt einfassen.

Jedes der Kontaktelemente "sitzt" mit seinem Basisabschnitt 122e zwischen den Kontaktfahnen 122 jeweils auf dem Randbereich der Leiterplatte 132, wobei der Lötstift 126 in eine Öffnung 134 der Leiterplatte 132 eingreift. Die Kontaktfahnen 122d kontaktieren jeweils Leiterbahnen 136' auf der Leiterplatte 132' einer Nachbarmodulscheibe oder liegen auf der Leiterplatte 132 auf. Die Kontaktfahnen 122a oder b kontaktieren dagegen die Leiterbahnen 136 der Leiterplatte 132, auf deren Rand das Kontaktelement 120 sitzt. Die Kontaktelemente sorgen somit für eine Weitergabe der Busleitersignale und/oder Potentiale von Platine zu Platine/Leiterplatte 132 bzw. von Modulscheibe zu Modulscheibe MS. Die Leiterplattenführung auf den Platinen 132 orientiert sich am gewählten Bussystem. Wie in Fig. 3 zu erkennen, liegen die Kontaktelemente 120 derart in der Modulscheibe MS bzw. in der Busleiteröffnung 10, das ein optimaler mechanischer Schutz des Kontaktelementes 120 gewährleistet wird. Die Kontaktfahnen 122c und d stehen zwar seitlich über die Hauptebene bzw. den Rand der eigentlichen Modulscheibe vor, sie werden (aber wie bei Datensteckern üblich) von einem umgebenden Schutzkragen 138 geschützt, der zur Seite bzw. zur nächsten Modulscheibe MS hin geöffnet ist und auch ein Führungselement für den Rand der benachbarten Leiterplatte 132' bildet. Die Leiterplatte 132 liegt zusammen mit dem Basisabschnitt 122e des Kontaktelementes 120 in einer Ausnehmung 140 des Basis-Klemmenkörpers 2, die parallel zur Tragschiene bzw. senkrecht zur Hauptebene der Modulscheiben MS ausgerichtet ist. Die Kontaktfahnen 122a,b liegen dagegen in einem in der Verlängerung der Leiterplattenebene der Leiterplatte 14 nach unten liegenden Aufnahmeraum /Ausnehmung 142 in dem Basis-Klemmenkörper 2, der nach oben hin von einer Öffnung 144 zur Durchführung und Zentrierung des unteren Randes der Leiterplatte 14 begrenzt wird. Zur in Fig. 3 rechten Seite der Modulschiebe MS hin werden sowohl die Ausnehmung 140 als auch die Ausnehmung 142 von einer Verschlußhalteplatte 146 mit einem Durchbruch 148 für die Leiterplatte 132 verschlossen (siehe auch Fig. 2). Die Verschlußhalteplatte 146 weist seitliche Rastvorsprünge 150 auf, die zum Eingriff in entsprechende Rastausnehmungen 152 im Basis-Klemmenkörper 2 ausgelegt sind und die Verschlußhalteplatte 146 hinterschnittartig im Basis-Klemmenkörper 2 halten.

Insgesamt umfaßt der interne Busleiterabschnitt sieben nebeneinanderliegende Kontaktelemente 122, welche die Busleiteröffnung 8 des internen Busleiterabschnittes 10 ausfüllen.

Ein besonderer Vorteil der Variante der Ansprüche 2 bis 8 liegt neben der stabilen und zuverlässigen Ausgestaltung der Kontaktelemente 120 in der leichten Herstellung und Montage des internen Busleiterabschnittes 10. Es ist nämlich möglich, die Kontaktelemente 120 aus einem übergreifenden Blechstreifen "vorzustanzen" und mit einer Art Sollbruchstelle an einem Trägerstreifen zu belassen und die Kontaktelemente 120 derart gemeinsam auf den Rand der Leiterplatte 132 zu setzen und dort zu verlöten. Erst im Anschluß an diesen Arbeitsgang wird der Trägerstreifen von den Kontaktelementen 120 abgetrennt und dann die komplette Einheit aus den Kontaktelementen 120 und der Leiterplatte 132 in die Busleiteröffnung 8 eingesetzt. Bei Bedarf können Teile des Kontaktelementes 120 zum Korrosionsschutz selektiv vergoldet werden.

Die Variante der Fig. 2 bis 8 bietet damit den Vorteil einer schnellen und kostengünstigen Montierbarkeit bei äußerst materialsparender, einteiliger Ausgestaltung der Kontaktelemente 120. Die Leiterplatte 132 ist zudem auf ihren beiden Außenflächen kontaktierter (Kontaktkräfte über in sich geschlossenes System). Insbesondere können die Kontaktkräfte "weich" bzw. niedrig ausgelegt werden.

Gegenüber dem Stand der Technik bietet diese Variante auch noch den zusätzlichen Vorteil, daß die Winkligkeit des Kontaktelemente 120 fest definiert ist und nicht von Toleranzen anderer Teile und deren Montage abhängig ist. Jeder Einzelkontakt bzw. jedes Kontaktelement 120 besteht zudem nicht wie beim Stand der Technik aus mehreren Teilen, sondern ist einstückig ausgebildet. Zudem sind nur sieben Lötstellen auf der Leiterplatte 132 und nicht vierzehn wie beim gattungsgemäßen Stand der Technik zu realisieren. Da zudem der Rand der Leiterplatten 132 und 14 direkt zur Kontaktierung genutzt wird, sind keine zusätzlichen Kontaktelemente auf den Leiterplatte 132, 14 notwendig.

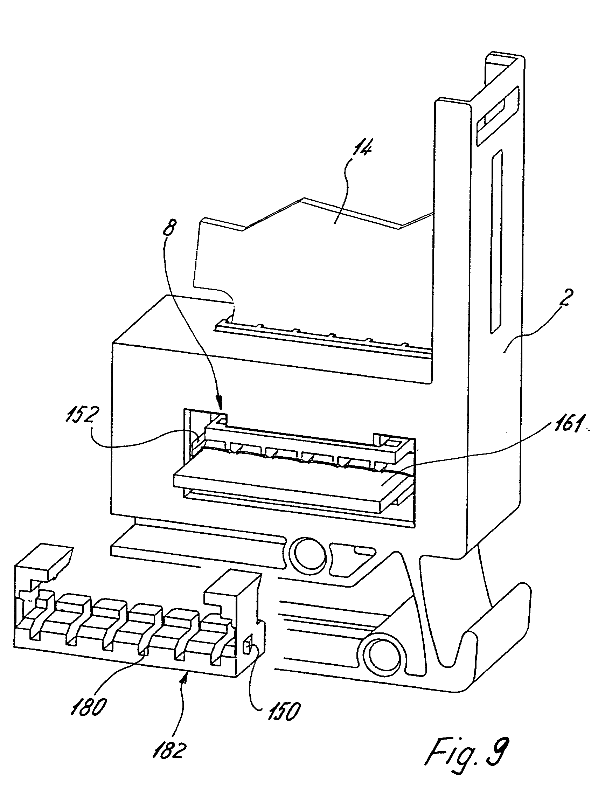

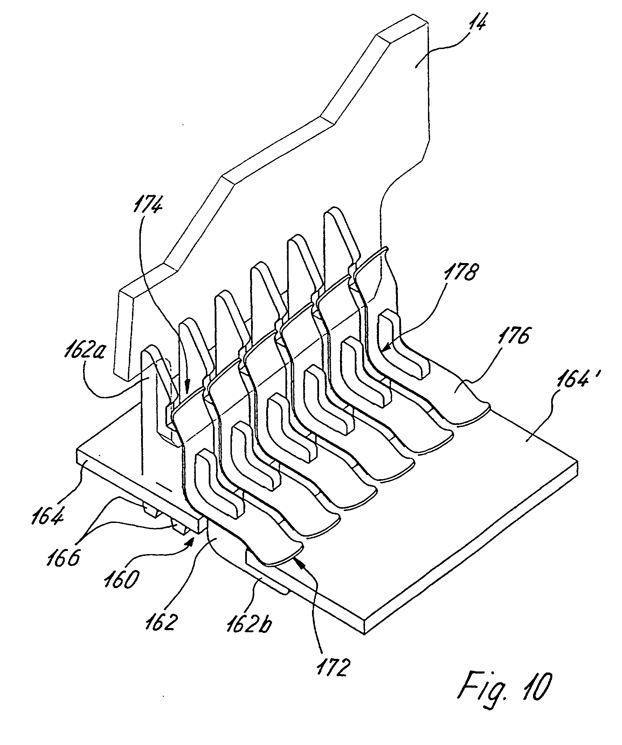

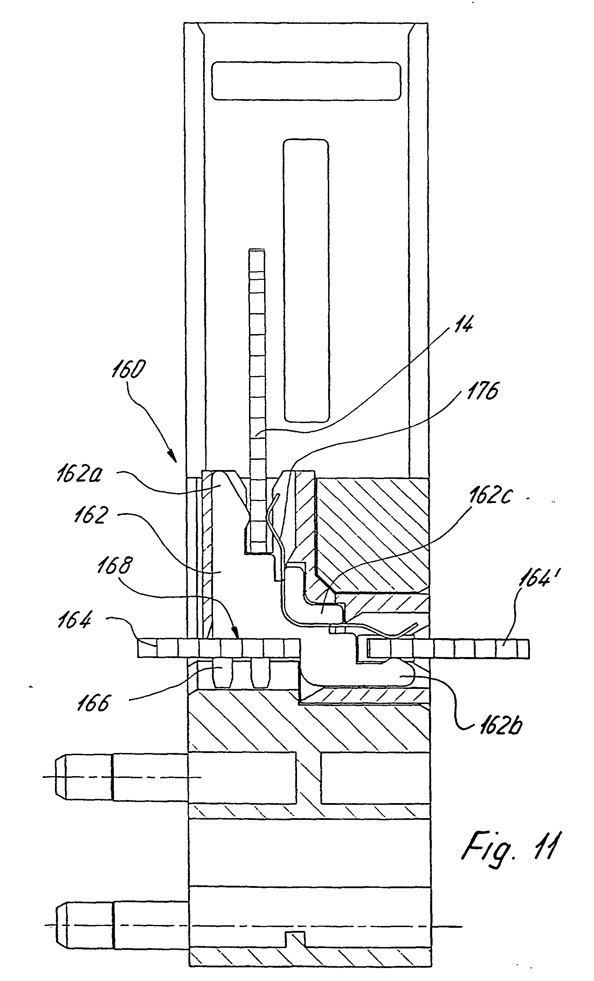

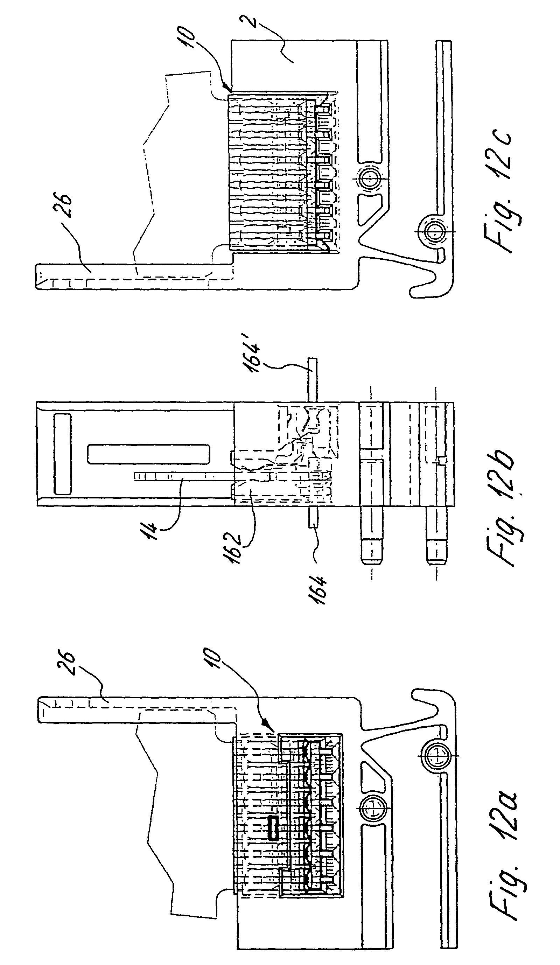

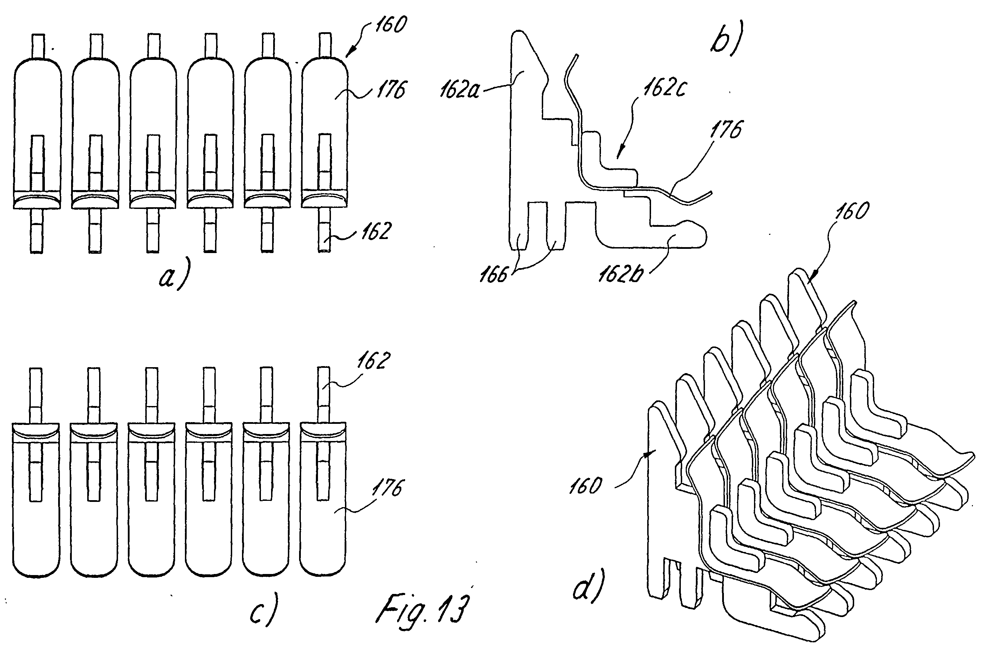

Die Fig. 9 bis 13 zeigen ein drittes Ausführungsbeispiel der Erfindung, bei dem - siehe hierzu insbesondere Fig. 10 und 11 - wiederum das Prinzip der Weiterleitung der Busleiterdaten- und -versorgungsleitungen von Basis-Klemmenkörper 2 zu Basis-Klemmenkörper 2 bzw. von Modulscheibe MS zu Modulscheibe MS mittels Leiterplatten 164, 164' - ähnlich zu den Leiterplatten 132 der Fig. 3 - erfolgt und innerhalb der Modulscheibe MS die Verbindung von der Leiterplatte 164 der jeweiligen Modulscheibe MS zur Leiterplatte 164' der benachbarten Modulschiebe MS' sowie zur Elektronikleiterplatte 14 mittels einer Mehrzahl an Kontaktelementen 160 erfolgt, die nebeneinander auf den Rand der Leiterplatte 164 aufgesetzt und dort verlötet sind. Die Kontaktelemente 160 sind jeweils zweistückig ausgebildet und umfassen einen im wesentlichen scheibenartigen Platinenkontakt 162, der sowohl senkrecht zur Leiterplatte 132 als auch senkrecht zur Elektronik-Leiterplatte 14 ausgerichtet ist sowie eine Kontaktfeder 176.

An den Rand des scheibenartigen Platinenkontaktes 162 sind zwei senkrecht vom Rand abstehende Lötstifte 166 angeformt, welche wiederum in Öffnungen 168 der Busleiterplatte 164 eingreifen, dort verlötet sind und für den Halt des Platinenkontaktes 162 auf der Leiterplatte 164 sorgen.

Der eigentliche Platinenkontakt 162 ist wiederum annähernd rechtwinklig ausgebildet und hat eine nach oben hin vorstehende obere Haltenase 162a und eine am Platinenrand der Leiterplatte 164 bis unterhalb der Leiterplatte 164 reichende und unterhalb der Leiterplattenebene im wesentlichen parallel zur Platine/Leiterplatte 164 ausgerichtete untere Haltenase 162b. Diese Haltenasen 162a und b sind jeweils zur Anlage ; an und/oder zur Kontaktierung der zugeordneten Leiterplattenränder 14 bzw. 164 ausgelegt. In seinem mittleren Bereich zwischen den Haltenasen 162a, b weist der Platinenkontakt 162 eine (doppelte) Stufung 162c auf. Die Haltenasen 162a und b bilden jeweils die eine Seite einer tulpenförmigen Aufnahme 172, 174, deren weitere, auf den jeweils gegenüberliegenden Seiten der Leiterplatten 14, 164 liegenden Seiten von einer Feder 176 aus einem Federstahlblatt gebildet werden, welches eine rechteckige, langgezogene Form aufweist und in der Ebene des Federstahlblattes rechtwinklig abgebogen ist. (ungefähr in der Mitte des Federstahlblattes parallel zu den kürzeren Seiten des Rechteckes). Die Feder 176 weist ferner eine zentrale Öffnung bzw. einen Längsschlitz 178 auf, welcher ungefähr die Breite bzw. Dicke des Platinenkontaktes 162 hat und im wesentlichen gleichmäßig beidseits des Knickes des Federstahlblattes ausgebildet ist. In diese Öffnung 178 greift die Stufung 162c des Platinenkontaktes ein, so daß die Feder 176 quasi auf dem Platinenkontakt 162 "sitzt" und die einander gegenüberliegenden Enden der Feder 176 die zweiten Seiten der tulpenförmigen Aufnahmen 172, 174 bilden. Sowohl die Enden der Feder 176 als auch die Enden der Haltenasen 162a, b sind hierzu mit einer "halb-"tulpenartigen Geometrie versehen. Eine U-förmige und nach oben offene, mit Einschnitten 180 versehene Verschlußhalteplatte 182 dient wiederum zur Aufnahme der Platinenkontakte 162. Die Verschlußhalteplatte 182 weist wiederum seitliche Rastvorsprünge 150 auf, die zum Eingriff in entsprechende Rastausnehmungen 152 im Basis-Klemmenkörper 2 ausgelegt sind und die Verschlußhalteplatte 182 hinterschnittartig im Basis-Klemmenkörper 2 halten.

Bei Bedarf ist der Platinenkontakt 162 voll vergoldet herstellbar (z.B. unkompliziert im Trommelgalvanikverfahren). Ein weiterer Vorteil ist darin zu sehen, daß die Leiterplatte 164 nur einseitig angefast werden muß. Zudem sind durch die Feder 176 die Kontaktkräfte wiederum relativ "weich" auslegbar.

Gegenüber der Lösung der Fig. 3 wird außerdem die Robustheit und die Stabilität der Mechanik nochmals deutlich heraufgesetzt, insbesondere sind die Kontaktelemente an sich quasi nicht labil, so daß eine sehr genau definierte Winkligkeit der Haltenasen 162a und b zueinander garantiert wird. Auch hier ist es zudem wie bei dem Ausführungsbeispiel der Fig. 3 nicht notwendig, auf der Elektronikleiterplatte zusätzliche Kontaktelemente anzuordnen, da zur Kontaktierung jeweils die Leiterplattenränder genutzt werden.

Die Einbindung der internen Busleiterabschnitts der Erfindung kann jeweils nach der in Fig. 8 des gattungsgemäßen Standes der Technik beschriebenen Art erfolgen, was durch eine entsprechende Leiterbahnführung auf den Leiterplatten/ Busleiterplatten gewährleistet wird. Dabei ist durch versetzte Datenleitungen logisch erkennbar, ob vor der aufgesteckten Elektronik-Leiterplatte des Teilnehmers (N) jeweils ein oder zwei Elektronik-Leiterplatten bzw. zwei Teilnehmer (N-1 oder N-2 oder N-1 und N-2 gemeinsam) von den Modulscheiben MS abgenommen wurden.

### Bezugszeichen

- Modulscheibe: MS
- Anschlußebenen: A, B, C, ...
- Mehrfachanschlüsse: A1, A2, ..., B1, B2, ...
- Schutzerde: PE
- Funktionserde: FE
- Stromzuführschienen: SP, SSI, SPE
- Steckrichtung: SR

- Basis-Klemmenträger: 2
- Kunststoff-Rastfüße: 4
- Basisabschnitt: 6
- Busleiteröffnung: 8
- Busleiterabschnitt: 10
- Umfangs-Ausnehmung: 12
- Elektronik-Leiterplatte: 14
- Öffnungen: 16, 17, 18
- Kontaktelemente: 20, 22
- Stecker: 24
- Steg: 26
- Einschubnut: 28
- Elektronikgehäuse: 29
- Anschlußabschnitt: 30
- Runde Öffnungen: 32
- Quadratische Öffnungen: 34
- Feder-Kontaktelemente: 36
- Öffnung: 38
- Kontaktelement: 40
- Aussparungen: 42
- Anschlußöffnungen: 44
- Abdeckgehäuse: 46
- Öffnungen: 48
- Nut: 50
- Grundwandung: 52
- Kennzeichnungskanal: 54
- Öffnung: 57
- FE-Kontakt: 58
- Potential-Kontaktierungsöffnung: 59
- Ausnehmung: 62
- Kodierlelement: 64
- Einzelgehäuse: 100
- längerer Schenkel: 100a
- kürzerer Schenkel: 100b
- Kontaktelement: 102
- Grundsteg: 102a
- Querstege: 102b, c
- kürzere Längsstege: 102d,e,f
- Seitliche Ausnehmung: 104
- Ausnehmungsbereich: 104a
- Steckkontaktöffnungen: 106a, b, c
- Auswölbung: 108
- Vorsprünge: 110
- Kontaktelement: 120
- Kontaktfahnen: 122a-d
- Einschnitte: 124
- Löt- und/oder Einpreßstift: 126
- tulpenartiger Aufnahmebereich: 128
- tulpenartiger Aufnahmebereich: 130
- Busleiterplatte: 132
- Öffnung: 134
- Leiterbahnen: 136
- Schutzkragen: 138
- Ausnehmung: 140
- Ausnehmung: 142
- Verschlußhalteplatte: 146
- Durchbruch: 148
- Rastvorsprünge: 150
- Rastausnehmungen: 152
- Kontaktelement: 160
- Platinenkontakt: 162
- Busleiterplatte: 164
- Lötstifte: 166
- Öffnungen: 168
- Haltenase: 162a,b
- Stufung: 162c
- tulpenförmige Aufnahmen: 172, 174
- Feder: 176
- Öffnung: 178
- Einschnitte: 180
- Verschlußhalteplatte: 182

## Patentansprüche

1. Busleiterabschnitt für ein elektrisches Gerät mit modularem Aufbau zur Steuerung und/oder Überwachung technischer Prozesse und/oder zur Industrie- und/oder Gebäudeautomatisierung,
a) mit wenigstens einem auf eine Tragschiene aufsetzbaren Anschlußmodul (M) mit Anschlüssen (A1, A2, B1, ...) für externe Leiter und mit einer Reihung scheibenförmiger Basis-Klemmenträger (2),
b) wobei innerhalb jedes Anschlußmodules (M) der interne Busleiterabschnitt (10) im wesentlichen parallel zur Tragschiene verläuft,
**dadurch gekennzeichnet**,
c) daß die Busleiterabschnitte (10) jedes einzelnen Basis-Klemmenträgers (2) jeweils eine Mehrzahl von im wesentlichen rechtwinklig ausgebildeten Kontaktelementen aufweisen, welche sowohl eine Busleiterplatte (132, 164) im jeweiligen Basis-Klemmenträger (2) als auch eine Busleiterplatte (132, 164) im jeweils benachbarten Basis-Klemmenträger (2) kontaktieren und derart eine direkte Busleiterverbindung zwischen den benachbarten Basis-Klemmenträgern (2) schaffen.

2. Busleiterabschnitt nach Anspruch 1, **gekennzeichnet durch** eine Aneinanderreihung von Einzelgehäusen (100), in die jeweils eines der Kontaktelement (102) eingesteckt ist.

3. Busleiterabschnitt nach Anspruch 2, **dadurch gekennzeichnet, daß** die Einzelgehäuse (100) mit zusammenwirkenden ersten und zweiten Rastmitteln versehen sind, welche das Zusammenrasten der Einzelgehäuse (100) ermöglichen.

4. Busleiterabschnitt nach Anspruch 1 oder 2, **dadurch gekennzeichnet, daß** jedes Einzelgehäuse (100) und jedes Kontaktelement (102) eine L-Form aufweisen.

5. Busleiterabschnitt nach einem der vorstehenden Ansprüche, **dadurch gekennzeichnet, daß** jedes Einzelgehäuse (100) an einer seiner L-förmigen Außenseiten mit einer seitlichen Ausnehmung (104) versehen ist, in welche das Kontaktelement (102) einsetzbar ist.

6. Busleiterabschnitt nach einem der vorstehenden Ansprüche, **dadurch gekennzeichnet, daß** das Kontaktelement (102) als einstückiges Stanz-/Biegeteil ausgebildet ist, welches einen längeren Grundsteg (102a) und zwei senkrecht zum Grundsteg 102a stehende Querstege (102b, c) sowie einen vom Ende des Quersteges (102b) und zwei vom Ende des Quersteges (102c) senkrecht abstehende Längsstege (102d,e,f) aufweist.

7. Busleiterabschnitt nach einem der vorstehenden Ansprüche, **dadurch gekennzeichnet, daß** zwischen den beiden Querstegen (102b,c) der Längssteg (102a) eine Biegung um 90° aufweist.

8. Busleiterabschnitt nach einem der vorstehenden Ansprüche, **dadurch gekennzeichnet, daß** die Quer- und Längsstege (102a-e) derart umgebogen sind, daß sich an den Enden des L-förmigen Kontaktelementes (102) zwei tulpenartige Steckkontaktöffnungen (106a, b) zur Aufnahme eines Leiterplattenrandes ausbilden.

9. Busleiterabschnitt nach einem der vorstehenden Ansprüche, **dadurch gekennzeichnet, daß** eine weitere, der Steckkontaktöffnung (106a) gegenüberliegende Steckkontaktöffnung (106c) zur Aufnahme eines Leiterplattenrandes durch den kürzeren Längssteg (102e) und eine Vertiefung/Auswölbung (108) im längeren Längssteg (102a) ausgebildet ist.

10. Busleiterabschnitt nach Anspruch 1, **dadurch gekennzeichnet, daß** der interne Busleiter (10) eine Mehrzahl von einstückigen Kontaktelementen (120) aufweist, die als Stanz-/Biegeteile aus einem Blechstreifen ausgebildet sind, welche im wesentlichen eine langgezogene, rechteckige Form aufweisen, wobei die beiden einander gegenüberliegenden schmaleren Seiten des Rechteckes zu tulpenförmigen Aufnahmebereichen (128, 130) aufgebogen sind.

11. Busleiterabschnitt nach Anspruch 10, **dadurch gekennzeichnet, daß** die beiden einander gegenüberliegenden schmaleren Seiten des Rechteckes jeweils geschlitzt ausgebildet sind.

12. Busleiterabschnitt nach einem der vorstehenden Ansprüche, **dadurch gekennzeichnet, daß** insgesamt vier Kontaktfahnen (122) am Kontaktelement (120) ausgebildet sind und daß im mittleren Bereich des Kontaktelementes (120) die eine der Längsseiten mit zwei zur Längsseite senkrechten Einschnitten (124) versehen ist, zwischen denen ein Lötstift (126) oder eine SMD-/SMT-Kontaktierungsfläche ausgebildet ist.

13. Busleiterabschnitt nach einem der vorstehenden Ansprüche, **dadurch gekennzeichnet, daß** zwei der Kontaktfahnen (122 a,b) im wesentlichen um 180° zum Lötstift (126) verdreht ausgerichtet sind, und zwar derart versetzt zueinander, daß zwischen den beiden Kontaktfahnen (122a, b) einer der tulpenartigen Aufnahmebereiche (128) zur Aufnahme eines Leiterplattenrandes ausgebildet ist.

14. Busleiterabschnitt nach einem der vorstehenden Ansprüche, **dadurch gekennzeichnet, daß** die den Kontaktfahnen (122a,b) am anderen Ende des Kontaktelementes (120) gegenüberliegenden Kontaktfahnen (122c,d) so geformt sind, daß sie die zweite tulpenförmige Aufnahme (130) für einen Leiterplattenrand ausbilden.

15. Busleiterabschnitt nach einem der vorstehenden Ansprüche, **dadurch gekennzeichnet, daß** jedes der Kontaktelemente (120) mit einem Basisabschnitt (122e) zwischen den Kontaktfahnen (122) jeweils auf dem Randbereich der Leiterplatte (132) sitzt.

16. Busleiterabschnitt nach einem der vorstehenden Ansprüche, **dadurch gekennzeichnet, daß** der Lötstift (126) in eine Öffnung (134) der Leiterplatte (132) eingreift.

17. Busleiterabschnitt nach einem der vorstehenden Ansprüche, **dadurch gekennzeichnet, daß** zumindest ein Teil der Kontaktfahnen (122) Leiterplattenränder kontaktiert.

18. Busleiterabschnitt nach einem der vorstehenden Ansprüche, **dadurch gekennzeichnet, daß** die Kontaktfahnen (122c und d) seitlich über den Rand der zugehörigen Modulscheibe vorstehen und von einem Schutzkragen (138) umgeben sind.

19. Busleiterabschnitt nach einem der vorstehenden Ansprüche, **dadurch gekennzeichnet, daß** die Leiterplatte (132) zusammen mit dem Basisabschnitt (122e) des Kontaktelementes (120) in einer Ausnehmung (140) des Basis-Klemmenkörpers (2) liegt.

20. Busleiterabschnitt nach einem der vorstehenden Ansprüche, **dadurch gekennzeichnet**, weitere der Kontaktfahnen (122a,b) in einem in der Verlängerung der Leiterplattenebene der Elektronik-Leiterplatte (14) nach unten liegenden Aufnahmeraum (142) im Basis-Klemmenkörper (2) angeordnet sind.

21. Busleiterabschnitt nach einem der vorstehenden Ansprüche, **dadurch gekennzeichnet, daß** die Ausnehmungen (142, 142) von einer Verschlußhalteplatte (146, 182) mit einem Durchbruch (148) für die Leiterplatte (132) verschlossen sind.

22. Busleiterabschnitt nach einem der vorstehenden Ansprüche, **dadurch gekennzeichnet, daß** die Verschlußplatte (146) weist seitliche Rastvorsprünge (150) aufweist, die zum Eingriff in entsprechende Rastausnehmungen (152) im Basis-Klemmenkörper (2) ausgelegt sind und die Verschlußhalteplatte (146, 182) im Basis-Klemmenkörper (2) halten.

23. Busleiterabschnitt nach Anspruch 1, **dadurch gekennzeichnet, daß** die Kontaktelemente (160) jeweils zweistückig ausgebildet sind und eine Kontaktfeder (176) sowie einen im wesentlichen scheibenartigen Platinenkontakt (162) umfassen, der sowohl senkrecht zur Leiterplatte (164) als auch senkrecht zu Elektronikleiterplatte (14) ausgerichtet ist.

24. Busleiterabschnitt nach einem der vorstehenden Ansprüche, **dadurch gekennzeichnet, daß** an den Rand des scheibenartigen Platinenkontaktes (162) zwei senkrecht vom Rand abstehende Lötstifte (166) angeformt sind, welche in Öffnungen (168) einer Leiterplatte (164) eingreifen und dort verankert / verlötet sind.

25. Busleiterabschnitt nach einem der vorstehenden Ansprüche, **dadurch gekennzeichnet, daß** der Platinenkontakt (162) zwei zueinander senkrechte Haltenasen (162a, b) aufweist.

26. Busleiterabschnitt nach einem der vorstehenden Ansprüche, **dadurch gekennzeichnet, daß** die Haltenasen (162a und b) jeweils zur Anlage an und/oder zur Kontaktierung der zugeordneten Leiterplatten (14 und 164) ausgelegt sind, im Zusammenspiel mit der Feder (176)

27. Busleiterabschnitt nach einem der vorstehenden Ansprüche, **dadurch gekennzeichnet, daß** der Platinenkontakt (162) in seinem mittleren Bereich zwischen den Haltenasen (162a, b) eine Stufung (162c) zur Aufnahme der Feder (176) aufweist.

28. Busleiterabschnitt nach einem der vorstehenden Ansprüche, **dadurch gekennzeichnet, daß** die Haltenasen (162a und b) jeweils die eine Seite einer tulpenförmigen Aufnahme (172, 174) bilden, deren weitere Seiten von der Feder (176) gebildet sind.

29. Busleiterabschnitt nach einem der vorstehenden Ansprüche, **dadurch gekennzeichnet, daß** die Feder (176) aus einem Federstahlblatt besteht, welches eine rechteckige, langgezogene Form aufweist und in der Ebene des Federstahlblattes rechtwinklig abgebogen ausgebildet ist.

30. Busleiterabschnitt nach einem der vorstehenden Ansprüche, **dadurch gekennzeichnet, daß** die Feder (176) einen Schlitz zur Aufnahme der Stufung (162c) des Platinenkontaktes (162) aufweist.

31. Busleiterabschnitt nach einem der vorhergehenden Ansprüche, **dadurch gekennzeichnet, daß** die Feder im wesentlichen senkrecht zum Platinenkontakt (162) ausgerichtet ist.

32. Busleiterabschnitt nach einem der vorstehenden Ansprüche, **gekennzeichnet durch** eine U-förmige, mit Einschnitten (182) versehene Halteplatte (180).

## Claims

1. Bus conductor section for an electrical apparatus with a modular structure for controlling and/or monitoring technical processes and/or for industrial and/or building automation,
a) comprising at least one connection module (M) which can be placed on a support rail with connections (A1, A2, B1, etc.) for external conductors and with a sequence of plate-shaped base terminal carriers (2),
b) wherein, within each connection module (M), the internal bus conductor section (10) extends substantially parallel to the support rail,
**characterised in that**,
c) the bus conductor sections (10) of each individual base terminal carrier (2) each have a plurality of substantially rectangular contact elements, which contact a bus printed circuit board (132, 164) in the respective base terminal carrier (2) and a bus printed circuit board (132, 164) in the respective adjacent base terminal carrier (2) and in this manner provide a direct bus conductor connection between the adjacent base terminal carriers (2).

2. Bus conductor section according to claim 1, **characterised by** a stringing together of individual housings (100) into which, in each case, one of the contact elements (102) is plugged.

3. Bus conductor section according to claim 2, **characterised in that** the individual housings (100) are provided with cooperating first and second latching means, which allow the individual housings (100) to be latched together.

4. Bus conductor section according to claim 1 or 2, **characterised in that** each individual housing (100) and each contact element (102) has an L-shape.

5. Bus conductor section according to any one of the preceding claims, **characterised in that** each individual housing (100) is provided, at one of its L-shaped outer sides with a lateral recess (104), into which the contact element (102) can be inserted.

6. Bus conductor section according to any one of the preceding claims, **characterised in that** the contact element (102) is configured as a one-piece punched/bent part, which has a relatively long base web (102a) and two transverse webs (102b, c) standing perpendicularly with respect to the base web (102a), and longitudinal webs (102d, e, f), one projecting perpendicularly from the end of the transverse web (102b) and two from the end of the transverse web (102c).

7. Bus conductor section according to any one of the preceding claims, **characterised in that** the longitudinal web (102a) has a bend through 90° between the two transverse webs (102b, c).

8. Bus conductor section according to any one of the preceding claims, **characterised in that** the transverse and longitudinal webs (102a to e) are bent in such a way that two tulip-like plug contact openings (106a, b) are configured to receive a printed circuit board edge at the ends of the L-shaped contact element (102).

9. Bus conductor section according to any one of the preceding claims, **characterised in that** a further plug contact opening (106c) opposing the plug contact opening (106a) is configured to receive a printed circuit board edge by means of the shorter longitudinal web (102e) and a recess/indentation (108) in the longer longitudinal web (102a).

10. Bus conductor section according to claim 1, **characterised in that** the internal bus conductor (10) has a plurality of one-piece contact elements (120), which are configured as punched/bent parts made of a sheet metal strip, which substantially have a drawn-out, rectangular form, the two narrower sides of the rectangle opposing one another being bent open to form tulip-shaped receiving regions (128, 130).

11. Bus conductor section according to claim 10, **characterised in that** the two narrower edges of the rectangle opposing one another are each slit.

12. Bus conductor section according to any one of the preceding claims, **characterised in that** a total of four contact lugs (122) are configured on the contact element (120) and that, in the central region of the contact element (120), one of the longitudinal sides is provided with two incisions (124) perpendicular to the longitudinal side, between which a solder pin (126) or an SMD/SMT contacting face is configured.

13. Bus conductor section according to any one of the preceding claims, **characterised in that** two of the contact lugs (122a, b) are substantially oriented rotated through 180° with respect to the solder pin (126), and specifically offset with respect to one another in such a way that one of the tulip-like receiving regions (128) for receiving a printed circuit board edge is configured between the two contact lugs (122a, b).

14. Bus conductor section according to any one of the preceding claims, **characterised in that** the contact lugs (122c, d) opposing the contact lugs (122a, b) at the other end of the contact element (120) are formed in such a way that they form the second tulip-shaped receiver (130) for a printed circuit board edge.

15. Bus conductor section according to any one of the preceding claims, **characterised in that** each of the contact elements (120) with a base section (122e) between the contact lugs (122) is seated in each case on the edge region of the printed circuit board (132).

16. Bus conductor section according to any one of the preceding claims, **characterised in that** the solder pin (126) engages in an opening (134) of the printed circuit board (132).

17. Bus conductor section according to any one of the preceding claims, **characterised in that** at least a portion of the contact lugs (122) contact printed circuit board edges.

18. Bus conductor section according to any one of the preceding claims, **characterised in that** the contact lugs (122c and d) project laterally over the edge of the associated module plate and are surrounded by a protective collar (138).

19. Bus conductor section according to any one of the preceding claims, **characterised in that** the printed circuit board (132) together with the base section (122e) of the contact element (120) is located in a recess (140) of the base terminal body (2).

20. Bus conductor section according to any one of the preceding claims, **characterised in that** further ones of the contact lugs (122a, b) are arranged in a receiving space (142) located at the bottom in the extension of the printed circuit board plane of the electronic printed circuit board (14), in the base terminal body (2).

21. Bus conductor section according to any one of the preceding claims, **characterised in that** the recesses (142, 142) are closed by a sealing holding plate (146, 182) with an opening (148) for the printed circuit board (132).

22. Bus conductor section according to any one of the preceding claims, **characterised in that** the sealing plate (146) has lateral latching projections (150), which are designed for engagement in corresponding latching recesses (152) in the base terminal body (2) and keep the sealing holding plate (146, 182) in the base terminal body (2).

23. Bus conductor section according to claim 1, **characterised in that** the contact elements (160) are designed in two pieces in each case and comprise a contact spring (176) and a substantially plate-like board contact (162), which is oriented both perpendicularly to the printed circuit board (164) and perpendicularly to the electronic circuit board (14).

24. Bus conductor section according to any one of the preceding claims, **characterised in that** two solder pins (166) projecting perpendicularly from the edge are moulded onto the edge of the plate-like board contact (162), and engage in openings (168) of a printed circuit board (164) and are anchored/soldered there.

25. Bus conductor section according to any one of the preceding claims, **characterised in that** the board contact (162) has two holding projections (162a, b) that are parallel to one another.

26. Bus conductor section according to any one of the preceding claims, **characterised in that** the holding projections (162a and b) are each designed to rest on and/or for contacting the associated printed circuit boards (14 and 164), in cooperation with the spring (176).

27. Bus conductor section according to any one of the preceding claims, **characterised in that** the board contact (162), in its central region between the holding projections (162a, b) has a graduation (162c) for receiving the spring (176).

28. Bus conductor section according to any one of the preceding claims, **characterised in that** the holding projections (162a and b) each form one side of a tulip-shaped recess (172, 174), the further sides of which are formed by the spring (176).

29. Bus conductor section according to any one of the preceding claims, **characterised in that** the spring (176) consists of a spring steel sheet, which has a rectangular, drawn-out shape and is configured to be bent a right angles in the plane of the spring steel sheet.

30. Bus conductor section according to any one of the preceding claims, **characterised in that** the spring (176) has a slit to receive the graduation (162c) of the board contact (162).

31. Bus conductor section according to any one of the preceding claims, **characterised in that** the spring is substantially oriented perpendicular to the board contact (162).

32. Bus conductor section according to any one of the preceding claims, **characterised by** a U-shaped holding plate (180) provided with incisions (182).

## Revendications

1. Tronçon conducteur d'un bus pour un appareil électrique, avec une structure modulaire, pour la commande et/ou la surveillance de processus techniques et/ou pour l'automatisation industrielle et/ou la gestion technique de bâtiments,
a) avec au moins un module de raccordement (M) encliquetable sur un profilé support avec raccordements (A1, A2, B1, ...) pour conducteurs externes et avec une rangée de porte-borne de base en forme de galette (2),
b) dans chacun des modules de raccordement (M), le tronçon conducteur interne du bus (10) étant orienté sensiblement parallèle au profilé support,
**caractérisé en ce que**
c) les tronçons conducteurs de bus (10) de chaque porte-borne de base (2) comportent plusieurs éléments de contact conformés sensiblement à angle droit, qui raccordent aussi bien une carte imprimée de bus (132, 164) dans le porte-borne de base (2) correspondant qu'une carte imprimée de bus (132, 164) dans le porte-borne de base (2) voisin et constituent, de cette manière, un raccordement direct au bus entre les porte-borne de base (2) voisins.

2. Tronçon conducteur d'un bus selon la revendication 1, **caractérisé en ce qu'**il comporte une juxtaposition de cages individuelles (100), dans chacune d'elles étant enfiché l'un des éléments de contact (102).

3. Tronçon conducteur d'un bus selon la revendication 2, **caractérisé en ce que** les cages individuelles (100) sont dotées de premiers et deuxièmes moyens de fixation par accrochage qui permettent de solidariser les cages individuelles (100).

4. Tronçon conducteur d'un bus selon la revendication 1 ou 2, **caractérisé en ce que** chaque cage individuelle (100) et chaque élément de contact (102) présentent une forme en L.

5. Tronçon conducteur d'un bus selon l'une des revendications précédentes, **caractérisé en ce que** la face extérieure en L de chaque cage individuelle (100) est dotée d'un évidement latéral (104) dans lequel peut se loger l'élément de contact (102).

6. Tronçon conducteur d'un bus selon l'une des revendications précédentes, **caractérisé en ce que** l'élément de contact (102) est constitué d'une pièce unique estampée/pliée qui comprend une barrette de base relativement longue (102a) et deux barrettes transversales (102b,c), perpendiculaires à la barrette de base (102a) ainsi que des barrettes longitudinales (102d, e, f), l'une partant perpendiculairement de l'extrémité de la barrette transversale (102b) et les deux autres partant perpendiculairement de l'extrémité de la barrette transversale (102c).

7. Tronçon conducteur d'un bus selon l'une des revendications précédentes, **caractérisé en ce qu'**entre les deux barrettes transversales (102b, c), la barrette longitudinale (102a) comporte un coude à 90°.

8. Tronçon conducteur d'un bus selon l'une des revendications précédentes, **caractérisé en ce que** les barrettes transversales et longitudinale (102a-e) sont pliées de telle sorte que deux ouvertures en U pour contacts enfichables (106a, b) sont formées à l'extrémité de l'élément de contact en L (102), pour recevoir un bord de carte imprimée.

9. Tronçon conducteur d'un bus selon l'une des revendications précédentes, **caractérisé en ce qu'**est formée une autre ouverture pour contact enfichable (106a), opposée à l'ouverture pour contact enfichable (106c), pour recevoir un bord de carte imprimée à travers la barrette latérale la plus courte (102e), ainsi qu'une cavité/courbure (108) dans la barrette longitudinale la plus longue (102a).

10. Tronçon conducteur d'un bus selon la revendication 1, **caractérisé en ce que** le tronçon conducteur d'un bus interne (10) comporte plusieurs éléments de contact d'un seul tenant (120) formés de pièces estampées/pliées à partir d'un ruban de tôle, présentant une forme sensiblement rectangulaire, allongée, les deux côtés opposés les plus étroits du rectangle étant cintrés pour former des zones réceptrices en U (128, 130).

11. Tronçon conducteur d'un bus selon la revendication 10, **caractérisé en ce que** les deux côtés les plus étroits opposés du rectangle présentent chacun une fente.

12. Tronçon conducteur d'un bus selon l'une des revendications précédentes, **caractérisé en ce que** quatre languettes de contact (122) au total sont formées sur l'élément de contact (120) et **en ce que** dans la zone médiane de l'élément de contact (120), l'un des côtés longitudinaux est doté de deux encoches (124) perpendiculaires au côté longitudinal, entre lesquelles est formé un picot à souder (126) ou une plage de raccordement à technologie de montage en surface SMD/SMT.

13. Tronçon conducteur d'un bus selon l'une des revendications précédentes, **caractérisé en ce que** deux des languettes de contact (122a, b) sont sensiblement tournées à 180° par rapport au picot à souder (126), et sont décalées entre elles de sorte qu'entre les deux languettes de contact (122a, b) est formée l'une des zones réceptrices en U (128) pour la réception d'un bord de carte imprimée.

14. Tronçon conducteur d'un bus selon l'une des revendications précédentes, **caractérisé en ce que** les languettes de contact (122c, d) opposées aux languettes de contact (122 a, b), à l'autre extrémité de l'élément de contact (120) sont formées de manière à constituer la deuxième zone réceptrice en U (130) pour un bord de carte imprimée.

15. Tronçon conducteur d'un bus selon l'une des revendications précédentes, **caractérisé en ce que** chaque élément de contact (120) est posé sur la bordure de la carte imprimée (132), par un tronçon de base (122e) entre les languettes de contact (122).

16. Tronçon conducteur d'un bus selon l'une des revendications précédentes, **caractérisé en ce que** le picot à souder (126) s'engage dans une ouverture (134) de la carte imprimée (132).

17. Tronçon conducteur d'un bus selon l'une des revendications précédentes, **caractérisé en ce qu'**au moins une partie des languettes de contact (122) raccorde des bords de la carte imprimée.

18. Tronçon conducteur d'un bus selon l'une des revendications précédentes, **caractérisé en ce que** les languettes de contact (122c et d) sont saillantes latéralement au-dessus du bord de la galette de module correspondante et sont entourées d'une collerette de protection (138).

19. Tronçon conducteur d'un bus selon l'une des revendications précédentes, **caractérisé en ce que** la carte imprimée (132) est posée avec le tronçon de base (122e) de l'élément de contact (120) dans un évidement (140) du corps du porte-borne de base (2).

20. Tronçon conducteur d'un bus selon l'une des revendications précédentes, **caractérisé en ce que** d'autres languettes de contact (122a, b) sont disposées dans un compartiment de réception (142), situé en dessous dans le prolongement du plan des plages conductrices de la carte imprimée électronique (14) à l'intérieur du corps du porte-borne de base (2).

21. Tronçon conducteur d'un bus selon l'une des revendications précédentes, **caractérisé en ce que** les évidements (142, 142) sont obturés par une plaque d'obturation et de fixation (146, 182) présentant une découpe (148) pour la carte imprimée (132).

22. Tronçon conducteur d'un bus selon l'une des revendications précédentes, **caractérisé en ce que** la plaque d'obturation (146) présente des tenons de fixation latéraux (150) qui sont conçus pour s'encliqueter dans des évidements de fixation (152) correspondants prévus dans le corps du porte-borne de base (2) et maintiennent la plaque d'obturation et de fixation (146, 182) dans le corps du porte-borne de base (2).

23. Tronçon conducteur d'un bus selon la revendication 1, **caractérisé en ce que** les éléments de contact (160) sont constitués chacun de deux parties et comprennent une lame de contact flexible (176) ainsi qu'un contact du genre platine, sensiblement en forme de plaquette (162), perpendiculaire à la fois à la carte imprimée (164) et à la carte imprimée électronique (14).

24. Tronçon conducteur d'un bus selon l'une des revendications précédentes, **caractérisé en ce que** sur le bord du contact du genre platine en forme de plaquette (162) sont formés deux picots à souder (166) saillants perpendiculairement au bord, qui s'engagent dans des ouvertures (168) d'un carte imprimée (164) et y sont ancrés/soudés.

25. Tronçon conducteur d'un bus selon l'une des revendications précédentes, **caractérisé en ce que** le contact du genre platine (162) comprend deux ergots de fixation perpendiculaires entre eux (162a, b).

26. Tronçon conducteur d'un bus selon l'une des revendications précédentes, **caractérisé en ce que** les ergots de fixation (162a et b) sont chacun conçus pour l'application contre et/ou pour le raccordement avec les cartes imprimées (14 et 164) correspondantes, en coopération avec la lame flexible (176).

27. Tronçon conducteur d'un bus selon l'une des revendications précédentes, **caractérisé en ce que** le contact du genre platine (162) comporte dans sa partie médiane, entre les ergots de fixation (162a, b), un épaulement (162c) permettant de recevoir la lame flexible (176).

28. Tronçon conducteur d'un bus selon l'une des revendications précédentes, **caractérisé en ce que** les ergots de fixation (162a et b) forment chacun un côté d'une zone réceptrice en U (172, 174) dont les autres côtés sont constitués par la lame flexible (176).

29. Tronçon conducteur d'un bus selon l'une des revendications précédentes, **caractérisé en ce que** la lame flexible (176) est constituée d'une feuille d'acier à ressort qui présente une forme rectangulaire, allongée et est pliée à angle droit dans le plan de la feuille d'acier à ressort.

30. Tronçon conducteur d'un bus selon l'une des revendications précédentes, **caractérisé en ce que** la lame flexible (176) présente une fente pour loger l'épaulement (162c) du contact du genre platine (162).

31. Tronçon conducteur d'un bus selon l'une des revendications précédentes, **caractérisé en ce que** la lame flexible est sensiblement perpendiculaire au contact du genre platine (162).

32. Tronçon conducteur d'un bus selon l'une des revendications précédentes, **caractérisé par** une plaque support (180) en forme de U, dotée d'encoches (182).
